# EUROPÄISCHE PATENTANMELDUNG

(11) **EP 4 571 823 A1**
(43) Veröffentlichungstag der Anmeldung: **18.06.2025**
(21) Anmeldenummer: 23215477.3
(22) Anmeldetag: 11.12.2023
(51) Int. Cl.: H01L 21/673

(54) **VORRICHTUNG UND VERFAHREN ZUM TROCKNEN VON SCHEIBENFÖRMIGEN SUBSTRATEN**

(71) Anmelder: Siltronic AG, 81677 München (DE)
(72) Erfinder: Reeske, Gregor, 09599 Freiberg (DE); Kühnstetter, Albert, 84489 Burghausen (DE); Ramm, Anett, 09599 Freiberg (DE); Voit, Mathias, 09627 Bobritzsch-Hilbersdorf (DE)
(74) Vertreter: Grundner, Sebastian

(57) **Zusammenfassung**

Vorrichtung zum Trocknen von scheibenförmigen Substraten umfassend einen Körper mit einer horizontalen Haupterstreckungsrichtung und einem Querschnittsprofil quer zur Haupterstreckungsrichtung, das sich in vertikaler Richtung nach oben verjüngt, wobei der Körper an seiner Oberseite mehrere Auflagepositionen aufweist, die dafür geeignet sind, scheibenförmige Substrate abzustützen,
die mehreren Auflagepositionen entlang der Haupterstreckungsrichtung angeordnet sind,
an die mehreren Auflagepositionen Flächen des Körpers angrenzen, die ausgehend von den Auflagepositionen abfallen,
zumindest ein Teil der an die Auflagepositionen angrenzenden, abfallenden Flächen des Körpers einen oberen Abschnitt und einen unteren Abschnitt aufweisen, und der obere Abschnitt hydrophiler als der untere Abschnitt ist.

## Beschreibung

### Technisches Gebiet

Gegenstand der vorliegenden Erfindung sind eine Vorrichtung zum Trocknen von scheibenförmigen Substraten und ein Verfahren zum Trocknen von scheibenförmigen Substraten.

### Stand der Technik

Scheiben aus Halbleitermaterial, beispielsweise Scheiben aus monokristallinem Silizium (Siliziumwafer), werden in einer Vielzahl von Prozessschritten hergestellt, die unter anderem das Ziehen eines Einkristallstabs aus einer Schmelze, das Zersägen des Kristalls in Scheiben, das Schleifen, das Kantenverrunden, das Polieren und das chemische Reinigen der Scheiben umfassen. Durch die chemische Reinigung werden Verunreinigungen entfernt und die Oberflächen der Scheiben passiviert. Eine Form der chemischen Reinigung ist die Nassreinigung, die eine anschließende Trocknung der Scheiben erfordert.

Im Rahmen der chemischen Reinigung werden die scheibenförmigen Substrate für einige Zeit in ein oder mehrere Bäder mit einer Flüssigkeit getaucht und dann so langsam entnommen, dass so wenig Flüssigkeitsreste wie möglich an den Substraten haften bleiben. Grund dafür ist, dass die an den scheibenförmigen Substraten anhaftenden Flüssigkeitsreste eine Quelle für Verunreinigungen darstellen und die Qualität der Oberfläche des scheibenförmigen Substrats, vor allem im Randbereich, signifikant beeinflussen können. Flüssigkeitsreste, die zunächst zwischen dem Scheibenhalter und einem Substrat haften, können sich auf den Seitenflächen des Substrats ausbreiten und nach dem Trocknen Partikel auf dem Substrat hinterlassen. Da die Flüssigkeitsreste schwerflüchtige Verbindungen wie Metallpartikel enthalten können, bleiben die Verunreinigungen auch nach dem Verdampfen der Flüssigkeit auf der Scheibenoberfläche zurück.

Zum Trocknen von in Flüssigkeit getauchten, scheibenförmigen Substraten bietet sich ein Verfahren an, in dessen Verlauf die Substrate aus der Flüssigkeit in einen Gasraum überführt werden, der Dampf enthält, der auf den Substraten nicht kondensiert und die Oberflächenspannung der auf den Substrat haftenden Flüssigkeitsresten herabsetzt. Das Verfahren und der damit genutzte physikalische Effekt sind in der EP0385536 A1 beschrieben, ebenso wie eine Vorrichtung, die zur Durchführung eines solchen Verfahrens geeignet ist.

Weitere Vorrichtungen und Verfahren zur Verbesserung der Reinigungsqualität in Bezug auf verbleibende Partikel auf dem scheibenförmigen Substrat werden auch in den Dokumenten DE 10 2014 207 266 A1, EP 3 840 021 A1, EP 3 840 022 A1 und EP 3 840 023 A1 beschrieben. Bei der Anwendung dieser Vorrichtungen und Verfahren bleiben jedoch immer noch Partikel übrig, die die Qualität der scheibenförmigen Substrate mindern. Aufgabe der vorliegenden Erfindung ist es, die im Stand der Technik beschriebenen Vorrichtungen und Verfahren zum Trocknen weiter zu verbessern und so die Anzahl von Partikeln zu verringern, die auf den getrockneten Substraten zurückbleiben.

### Technische Aufgabe der Erfindung und deren Lösung

Ziel der vorliegenden Erfindung ist es deshalb, eine Vorrichtung und ein Verfahren zur Trocknung von scheibenförmigen Substraten bereitzustellen, die es ermöglichen, die Flüssigkeitsreste, und damit die in der Flüssigkeit enthaltenen Partikel, die an den scheibenförmigen Substraten haften, besser und effizienter zu entfernen.

Die Aufgabe wird dabei erfindungsgemäß gelöst durch eine Vorrichtung zum Trocknen von scheibenförmigen Substraten gemäß dem ersten Aspekt der vorliegenden Erfindung.

Diese Vorrichtung umfasst einen Körper mit einer horizontalen Haupterstreckungsrichtung und einem Querschnittsprofil quer zur Haupterstreckungsrichtung, das sich in vertikaler Richtung nach oben verjüngt,
wobei der Körper an seiner Oberseite mehrere Auflagepositionen aufweist, die dafür geeignet sind, scheibenförmige Substrate abzustützen,
die mehreren Auflagepositionen entlang der Haupterstreckungsrichtung angeordnet sind,
an die mehreren Auflagepositionen Flächen des Körpers angrenzen, die ausgehend von den Auflagepositionen abfallen,
zumindest ein Teil der an die an die Auflagepositionen angrenzenden, abfallenden Flächen des Körpers einen oberen Abschnitt und einen unteren Abschnitt aufweisen, und
der obere Abschnitt hydrophiler als der untere Abschnitt ist.

Es wurde überraschend festgestellt, dass durch die Ausgestaltung der an die Auflagepositionen angrenzenden, von den Auflagepositionen aus abfallenden Flächen mit einem oberen, hydrophileren Abschnitt und einem unteren hydrophoberen Abschnitt Flüssigkeitsreste schneller und effizienter entfernt werden können und so der Grad der Verunreinigungen auf der Oberfläche eines scheibenförmigen Substrates weiter verringert werden kann.

Gemäß dem zweiten Aspekt ist die vorliegende Erfindung auf ein Verfahren zum Trocknen von scheibenförmigen Substraten, die in eine Flüssigkeit getaucht sind, gerichtet. Das Verfahren umfasst die folgenden Schritte:
das Positionieren der in die Flüssigkeit getauchten, scheibenförmigen Substrate auf der Vorrichtung gemäß dem ersten Aspekt der vorliegenden Erfindung; und
das Überführen der scheibenförmigen Substrate mit der Vorrichtung aus der Flüssigkeit in einen Gasraum enthaltend einen Dampf, der auf den scheibenförmigen Substraten nicht kondensiert und die Oberflächenspannung von Flüssigkeitsresten, die an den scheibenförmigen Substraten haften, herabsetzt.

In diesem Verfahren können Flüssigkeitsreste zwischen den scheibenförmigen Substraten und der Vorrichtung, die die Scheiben abstützt, über die an die Auflagepositionen angrenzenden, nach unten geneigten Flächen des Körpers ablaufen und so entfernt werden. Es kann also darauf verzichtet werden, die Flüssigkeitsreste zwischen den scheibenförmigen Substraten und den Scheibenhalter aktiv zu entfernen.

Dadurch, dass der obere Abschnitt hydrophiler ausgestaltet ist, können wässrige Flüssigkeitsreste oder Flüssigkeitsreste mit polaren Lösungsmittelanteilen, die sich am unteren Rand der scheibenförmigen Substrate angesammelt haben, an den Auflagepositionen leichter auf die angrenzenden, nach unten abfallenden Flächen des Körpers übergehen. Dadurch, dass der untere Abschnitt der Flächen hydrophober ist, können die Flüssigkeitsreste leichter von den Flächen abgeführt und in das Flüssigkeitsbad zurückgeführt werden. Dies ermöglicht eine effiziente Entfernung von Flüssigkeitsresten von den scheibenförmigen Substraten. Dadurch kann die Anzahl der nach der Trocknung auf den scheibenförmigen Substraten verbliebenen Partikel verringert werden. Außerdem wird durch das verbesserte Abfließen der Flüssigkeitsreste bei der Entnahme der Substrate aus dem Bad die Nettoentnahme an Reinigungsflüssigkeit weiter verringert, was die Wirtschaftlichkeit der chemischen Reinigung verbessert. Außerdem kann durch das verbesserte Abfließen der Flüssigkeitsreste die Menge an Flüssigkeit, die von der Substratoberfläche verdampft reduziert werden, was zu einer Verbesserung der Atmosphäre im Reinraum führt.

### Kurzbeschreibung der Figuren

**Fig. 1** zeigt einen Körper (1) einer erfindungsgemäßen Vorrichtung zum Trocknen scheibenförmiger Substrate. Der Körper hat ein Querschnittsprofil (3) quer zur Haupterstreckungsrichtung (2), das sich in vertikaler Richtung nach oben verjüngt. Der Körper hat an seiner Oberseite ein durch eine Zick-Zack-Form gekennzeichnetes Kantenprofil (6), dass entlang der Haupterstreckungsrichtung (2) verläuft. Die einzelnen in Haupterstreckungsrichtung aneinanderstoßenden Kanten (4) bilden tiefer liegende Knicke (5), die als Auflageposition für die scheibenförmige Substrate dienen.
**Fig. 2a** zeigt das Querschnittsprofil und **Fig. 2b** das Längsprofil des in **Fig. 1** dargestellten Körpers (1).

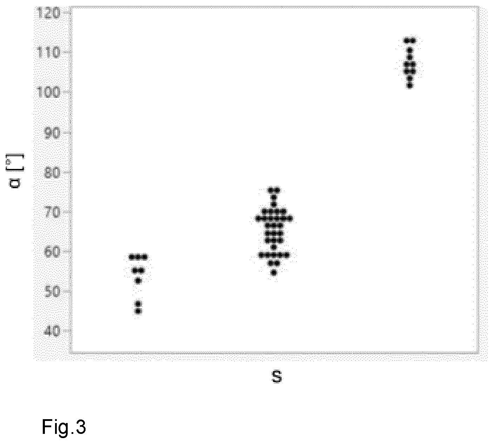

**Fig. 3** zeigt die Messergebnisse der Bestimmung des Kontaktwinkels α eines Wassertropfens auf an die Auflagepositionen angrenzenden, abfallenden Flächen des Körpers der erfindungsgemäßen Vorrichtung, in Abhängigkeit vom Abstandes s von der Auflageposition.

### Detaillierte Beschreibung der Erfindung

Scheibenförmige Substrate im Sinne der vorliegenden Erfindung sind beispielsweise Scheiben aus Halbleitermaterial, vorzugsweise Scheiben aus einkristallinem Silizium, das wahlweise dotiert ist. Die scheibenförmigen Substrate haben vorzugsweise einen Durchmesser von 150 bis 450 mm, besonders bevorzugt 200 mm oder 300 mm, am meisten bevorzugt 300 mm.

Die erfindungsgemäße Vorrichtung zum Trocknen von scheibenförmigen Substraten gemäß dem ersten Aspekt der vorliegenden Erfindung umfasst einen Körper mit einer horizontalen Haupterstreckungsrichtung und einem Querschnittsprofil quer zur Haupterstreckungsrichtung, das sich in vertikaler Richtung nach oben verjüngt. Vorzugsweise ist das Querschnittsprofil symmetrisch in Bezug auf eine vertikale Symmetrieachse. Vorzugsweise weist das Querschnittsprofil des Körpers in seinem oberen Teil einen spitzen Winkel auf. In diesem Fall bildet der Scheitelpunkt des spitzen Winkels als höchsten Punkt des Querschnittsprofils den Auflagepunkt zur Abstützung des scheibenförmigen Substrats.

Vorzugsweise verjüngt sich der Körper in vertikaler Richtung nach oben zu einer Kante oder einem Kantenprofil. Das Kantenprofil besteht aus mehreren aneinanderstoßenden Kanten, die in derselben Ebene liegen, vorzugsweise in einer Ebene senkrecht zum Querschnittsprofil. An jeder Kante des Kantenprofils stoßen zwei von der Kante aus abfallende Flächen aneinander. Die Punkte, an denen jeweils zwei Kanten des Kantenprofils aneinanderstoßen werden im Folgenden als Knicke bezeichnet. Beispielsweise kann das Kantenprofil ein Zick-Zack-Profil sein. Das Kantenprofil verläuft dabei vorzugsweise entlang der Haupterstreckungsrichtung. Dies bedeutet, dass das Kantenprofil und die Haupterstreckungsrichtung in derselben Ebene liegen, welche vorzugsweise senkrecht zur Querschnittsfläche angeordnet ist.

Der Körper weist an seiner Oberseite mehrere Auflagepositionen auf, die dafür geeignet sind, scheibenförmige Substrate abzustützen, wobei die mehreren Auflagepositionen entlang der Haupterstreckungsrichtung angeordnet sind und an Flächen des Körpers angrenzen, die ausgehend von den Auflagepositionen abfallen. Die Auflagepositionen werden vorzugsweise durch eine oder mehrere Kanten an der Oberseite des Körpers gebildet, wobei an jeder Kante zwei abfallende Flächen aneinanderstoßen. Vorzugsweise werden die Auflagepositionen durch Kanten gebildet, an denen von der Kante aus abfallende Flächen des Körpers aneinanderstoßen. Zumindest ein Teil der an die Auflagepositionen angrenzenden abfallenden Flächen weist einen oberen Abschnitt und einen unteren Abschnitt auf, wobei der obere Abschnitt hydrophiler als der untere Abschnitt ist. Vorzugsweise weisen alle an die Auflagepositionen angrenzenden abfallenden Flächen einen oberen Abschnitt und einen unteren Abschnitt auf, wobei der obere Abschnitt hydrophiler als der untere Abschnitt ist.

Wenn sich der Körper in vertikaler Richtung nach oben zu einer Kante verjüngt, beispielsweise wenn der Körper als keilförmiger Körper ausgestaltet ist, dient die nach oben weisende Kante zur Auflage der scheibenförmigen Substrate. In diesem Fall stellt die eine, nach oben weisende Kante mehrere Auflagepositionen bereit. Wenn sich der Körper in vertikaler Richtung nach oben zu einem Kantenprofil verjüngt werden die Auflagepositionen vorzugsweise durch Knicke im Kantenprofil gebildet, besonders bevorzugt durch die nach unten weisenden Knicke. Wenn das Kantenprofil ein Zick-Zack-Profil ist, dienen vorzugsweise die Knicke als Auflageposition für die scheibenförmigen Substrate, von denen aus zwei Kanten nach oben verlaufen. Eine Auflageposition kann also auch durch zwei Kanten gebildet werden, die an der Oberseite des Körpers entlang der Haupterstreckungsrichtung verlaufen, aneinander angrenzen, und eine unterschiedliche Neigung in Bezug auf die Horizontale aufweisen.

Die Auflageposition können auch als Aussparung an der Oberseite des Körpers quer zur Haupterstreckungsrichtung ausgestaltet sein. Die Aussparung kann das Verrutschen oder Kippen des an der Auflageposition gestützten scheibenförmigen Substrates entlang der Haupterstreckungsrichtung verringern oder ganz vermeiden, insbesondere wenn die scheibenförmigen Substrate quer zur Haupterstreckungsrichtung angeordnet sind. Die Ausdehnung der einzelnen Aussparungen entlang der Haupterstreckungsrichtung übersteigt dabei die Dicke der scheibenförmigen Substrate, so dass diese in die Aussparungen eingesetzt und durch diese quer zur Haupterstreckungsrichtung gestützt werden können. Die Aussparungen verlaufen vorzugsweise in Querrichtung, also senkrecht zur Haupterstreckungsrichtung und senkrecht zur Vertikalen. Die Aussparungen können dabei quaderförmig, abgeschrägt, V-förmig oder an ihrer Unterseite abgerundet sein.

An die Auflagepositionen grenzen Flächen des Körpers an, die ausgehend von den Auflagepositionen nach unten abfallen. Zumindest ein Teil dieser Flächen hat jeweils einen oberen Abschnitt und einen unteren Abschnitt, wobei der obere Abschnitt hydrophiler als der untere Abschnitt ist. Vorzugsweise grenzen an jede Auflageposition, die vorzugsweise durch eine oder mehrere Kanten gebildet wird, mindestens zwei nach unten abfallende Flächen mit jeweils einem oberen Abschnitt und einem unteren Abschnitt an, wobei der obere Abschnitt hydrophiler als der untere Abschnitt ist. Vorzugsweise sind die mindestens zwei nach unten abfallende Flächen an gegenüberliegenden Seiten ausgehend von der jeweiligen Auflageposition angeordnet.

Eine nach unten abfallende Fläche im Sinne der vorliegenden Erfindung kann beispielsweise eine Neigung von mehr als 10° und weniger als 80° in Bezug auf die Vertikale haben. Eine abfallende Fläche im Sinne der vorliegenden Erfindung kann auch gekrümmt oder gewölbt sein. Abfallend im Sinne der vorliegenden Erfindung bedeutet, dass der an die Auflageposition angrenzende Teil der Fläche weiter oben liegt als ein weiter von der Auflageposition entfernter Teil der Fläche. Somit können Flüssigkeitsreste mit Hilfe der Schwerkraft über die abfallenden Flächen von den auf den Auflagepositionen abgestützten Substraten abgeführt werden.

Der obere Abschnitt grenzt vorzugsweise direkt an eine Auflageposition des Körpers an. Dadurch, dass der obere Abschnitt hydrophiler als der untere Abschnitt ausgestaltet ist, können wässrige Flüssigkeitsreste, beispielsweise in Form von Tropfen, leichter vom unteren Randbereich der vom Körper abgestützten, scheibenförmigen Substrate auf den Körper übertragen werden und so vom Substrat entfernt werden. Vorzugsweise ist die Oberfläche im oberen Abschnitt der an die Auflagepositionen angrenzenden, nach unten abfallende Flächen des Körpers hydrophiler als die Oberfläche des scheibenförmigen Substrates. In diesem Fall können wässrige Flüssigkeitsreste vom Substrat zum oberen Abschnitt abfließen. Außerdem wird in diesem Fall eine sich bei der Trennung von Substrat und Körper ausbildende Wasserbrücke zum hydrophileren Körper, beziehungsweise zum hydrophileren oberen Abschnitt der an die Auflageposition angrenzenden Fläche, gezogen und somit vom Substrat entfernt. Durch die Schwerkraft fließen diese Flüssigkeitsreste dann vom oberen zum unteren Abschnitt der abfallenden Flächen des Körpers. Dadurch, dass die Oberfläche des unteren Abschnittes hydrophober ausgestaltet ist, ist diese weniger gut benetzbar, so dass die Flüssigkeitsreste weiter abfließen und somit vom Körper zurück in das Flüssigkeitsbad oder einen anderen Auffangbehälter überführt werden können.

Die Hydrophilie ist ein Maß für die Benetzbarkeit. Eine hydrophilere Oberfläche hat also eine bessere Benetzbarkeit in Bezug auf Wasser. In der vorliegenden Erfindung wird der Kontaktwinkel α eines Tropfens einer Flüssigkeit an einer bestimmten Stelle einer Oberfläche als Maß für die Hydrophilie an dieser Stelle der Oberfläche herangezogen. Vorzugsweise wird der Kontaktwinkel α eines Wassertropfens, besonders bevorzugt eines Tropfens entionisierten Wassers, zur Bestimmung der Hydrophilie herangezogen. Eine hydrophilere Oberfläche im Sinne der vorliegenden Erfindung ist eine Oberfläche, auf der ein Wassertropfen einen kleineren Kontaktwinkel α aufweist, im Vergleich zu einer anderen Oberfläche. Eine hydrophobere Oberfläche im Sinne der vorliegenden Erfindung ist eine Oberfläche, auf der ein Wassertropfen einen grö-ßeren Kontaktwinkel α aufweist, im Vergleich zu einer anderen Oberfläche. Vorzugsweise ist eine hydrophilere Oberfläche im Sinne der vorliegenden Erfindung dadurch gekennzeichnet, dass ein Wassertropfen, vorzugsweise ein Tropfen entionisierten Wassers, auf ihr einen Kontaktwinkel α von nicht mehr als 45°, mehr bevorzugt einen Kontaktwinkel α von nicht mehr als 40°, am meisten bevorzugt nicht mehr als 30° aufweist. In einer Ausführungsform der vorliegenden Erfindung ist der hydrophilere, obere Abschnitt der an die Auflagepositionen angrenzenden Flächen so ausgestaltet, dass ein Wassertropfen, vorzugsweise ein Tropfen entionisierten Wassers, auf ihm einen Kontaktwinkel von nicht weniger als 20° und nicht mehr als 30° hat. Dementsprechend ist eine hydrophobere Oberfläche im Sinne der vorliegenden Erfindung dadurch gekennzeichnet, dass ein Wassertropfen, vorzugsweise ein Tropfen entionisierten Wassers, auf ihr einen Kontaktwinkel α von nicht weniger als 50°, vorzugsweise nicht weniger als 60° aufweist.

Vorzugsweise ist der Kontaktwinkel α eines Tropfens einer Flüssigkeit an den an die Auflagepositionen angrenzenden, nach unten abfallenden Flächen des Körpers eine monotone Funktion des Abstand s von der Auflageposition. Besonders bevorzugt ist der Kontaktwinkel α eines Wassertropfens an den an die Auflagepositionen angrenzenden, nach unten abfallenden Flächen des Körpers eine monotone steigende Funktion des Abstandes s von der Auflageposition. Der Kontaktwinkel α eines Wassertropfens auf einer an die Auflagepositionen angrenzenden, nach unten abfallenden Flächen des Körpers steigt also mit zunehmendem Abstand s an oder bleibt gleich.

Der Kontaktwinkel α kann gemäß dem folgenden Verfahren bestimmt werden:
(i) Benetzen mindestens einer Stelle einer Fläche, vorzugsweise mindestens einer Stelle des oberen Abschnittes und mindestens einer Stelle des unteren Abschnittes einer abfallenden Fläche des Körpers, mit jeweils einem Tropfen einer Flüssigkeit;
(ii) Aufnehmen eines Bildes jedes Tropfens, vorzugsweise eines Schattenbildes;
(iii) Bestimmen der Kontur des jeweiligen Tropfens ausgehend von dem jeweiligen Bild, vorzugsweise dem Schattenbild, mittels einer geeigneten Software; und
(iv) Bestimmen des Kontaktwinkels zwischen der Oberfläche und dem jeweiligen Tropfen ausgehend von der bestimmten Kontur des jeweiligen Tropfens.

Im Schritt (i) wird die zu untersuchende Stelle der Oberfläche mit einem Tropfen einer Flüssigkeit; vorzugweise mit einem Wassertropfen, besonders bevorzugt mit einem Tropfen entionisierten Wassers, benetzt. Im Schritt (ii) wird ein Bild des Tropfens, vorzugsweise ein Schattenbild, mit Hilfe einer Kamera aufgenommen. Im Schritt (iii) wird dann die Kontur des Tropfens ausgehend von dem Bild mittels einer geeigneten Software bestimmt. Dabei kann mittels einer Graustufenanalyse des Bildes eine Konturerkennung durchgeführt werden und anschließend ein die Tropfenkontur beschreibendes, geometrisches Modell identifiziert werden. Die Identifikation des die Tropfenkontur beschreibenden, geometrischen Modells kann beispielsweise durch Fitten erfolgen. Der Kontaktwinkel ergibt sich aus dem Winkel zwischen der ermittelten Tropfenkontur-Funktion und der Oberfläche der untersuchten Stelle, deren Projektion im Tropfenbild als Basislinie bezeichnet werden kann. Als die Tropfenkontur beschreibende geometrische Modelle können beispielsweise Kreis, Kegelschnitt, Ellipse oder Polynome herangezogen werden.

Der Körper kann aus Metall, Keramik oder Kunststoff bestehen. Vorzugsweise besteht der Körper aus einem thermoplastischen Kunststoff, am meisten bevorzugt aus einem hochtemperaturbeständigen thermoplastischen Kunststoff. Der hochtemperaturbeständige thermoplastische Kunststoff kann beispielsweise ein Polyaryletherketon, vorzugsweise Polyetheretherketon (PEEK) sein, welches eine hohe chemische Beständigkeit, Verschleißfestigkeit und gute Gleiteigenschaften aufweist. Der Körper der erfindungsgemäßen Vorrichtung zum Trocknen von scheibenförmigen Substraten besteht also vorzugsweise aus PEEK.

Die Hydrophilie einer Oberfläche kann durch physikalische Methoden, beispielsweise Plasmabehandlung, oder durch chemische Methoden, beispielsweise durch Oberflächenreaktionen, eine Belegung oder einer Einlagerung einer chemischen Verbindung, modifiziert werden.

So kann die Hydrophilie einer Oberfläche eines thermoplastischen Kunststoffes wie PEEK durch direkte Gasphasenfluorierung erhöht werden. Beispielsweise kann die Oberfläche eines Körpers aus PEEK durch Behandlung mit einem Gasgemisch aus Fluor und Luft behandelt werden, wobei das Gasgemisch einen Fluorgehalt von 5 mol% Fluor aufweisen kann.

Oberflächen können auch unter Verwendung eines Lasers hydrophilisiert werden. So können Oberflächen von metallischen Werkstoffen oder Keramiken mit Hilfe eines Lasers in Luftatmosphäre gereinigt werden, was zu einer hydrophileren Oberfläche führt. Eine Hydrophilisierung einer Oberfläche kann auch unter Verwendung eines Lasers und einer Silikatisierungsflüssigkeit erfolgen, wodurch die Oberfläche gereinigt und zusätzlich funktionalisiert wird. Dies führt dazu, dass die behandelte Oberfläche noch hydrophiler wird. Die Silikatisierung mittels Laser kann in einem Tauchbad durchgeführt werden Je nach eingesetzter Optik kann die örtliche Auflösung variiert werden, wobei der Durchmesser des kleinstmöglichen Laserspots weniger als 100 µm beträgt. Durch die Verwendung eines Lasers erfolgt die Reinigung und gegebenenfalls die Silikatisierung mit einer sehr hohen Ortsauflösung. Dadurch ist dieses Verfahren besonders gut dafür geeignet, Oberflächen mit verschiedenen Abschnitten mit einem unterschiedlichen Grad an Hydrophilie herzustellen.

Gemäß dem zweiten Aspekt ist die vorliegende Erfindung auf ein Verfahren zum Trocknen von scheibenförmigen Substraten, die in eine Flüssigkeit getaucht sind, gerichtet. Das Verfahren umfasst die folgenden Schritte:
das Positionieren der in die Flüssigkeit getauchten, scheibenförmigen Substrate auf der Vorrichtung gemäß dem ersten Aspekt der vorliegenden Erfindung; und
das Überführen der scheibenförmigen Substrate mit der Vorrichtung aus der Flüssigkeit in einen Gasraum enthaltend einen Dampf, der auf den scheibenförmigen Substraten nicht kondensiert und die Oberflächenspannung von Flüssigkeitsresten, die an den scheibenförmigen Substraten haften, herabsetzt.

In diesem Verfahren können Flüssigkeitsresten zwischen den scheibenförmigen Substraten und den Scheibenhalter über die an die Auflagepositionen angrenzenden, nach unten geneigten Flächen des Körpers der Vorrichtung ablaufen und so entfernt werden. Es kann also darauf verzichtet werden, die Flüssigkeitsreste zwischen den scheibenförmigen Substraten und den Scheibenhalter aktiv zu entfernen.

Ein Dampf, der nicht auf den Substraten kondensiert, hat einen Dampfdruck, der bei der Temperatur des Bades und der Substrate nicht gesättigt ist, während ein Dampf, der auf den Substraten kondensiert, tatsächlich einen solchen gesättigten Dampfdruck hat. Die Substrate können in verschiedenen Flüssigkeitsbädern behandelt werden. Wenn das Reinigungsbad Wasser enthält, wird vorzugsweise der Dampf eines organischen Lösungsmittels, vorzugsweise ein oder mehrere Verbindungen ausgewählt aus Alkoholen, Glykolen, Aldehyden, Estern, Ketonen oder Tetrahydrofuran, verwendet. Das erfindungsgemäße Verfahren kann auch dann angewendet werden, wenn das Bad andere polare Flüssigkeiten, beispielsweise Alkohole, enthält. Die Substrate können dann direkt aus dem Alkohol mit dem Dampf des organischen Lösungsmittels 1,1,1-Trifluortrichlorethan in Kontakt gebracht werden.

Dadurch, dass der obere Abschnitt hydrophiler ausgestaltet ist, können wässrige Flüssigkeitsreste oder Flüssigkeitsreste mit polaren Lösungsmittelanteilen, die sich am unteren Rand der scheibenförmigen Substrate angesammelt haben, an den Auflagepositionen leichter auf die angrenzenden, nach unten abfallenden Flächen des Körpers übergehen. Dadurch, dass der untere Abschnitt der Flächen hydrophober ist, können die Flüssigkeitsreste leichter von den Flächen abgeführt und in das Flüssigkeitsbad zurückgeführt werden.

### Beschreibung eines erfindungsgemäßen Ausführungsbeispiels und eines Vergleichsbeispiels

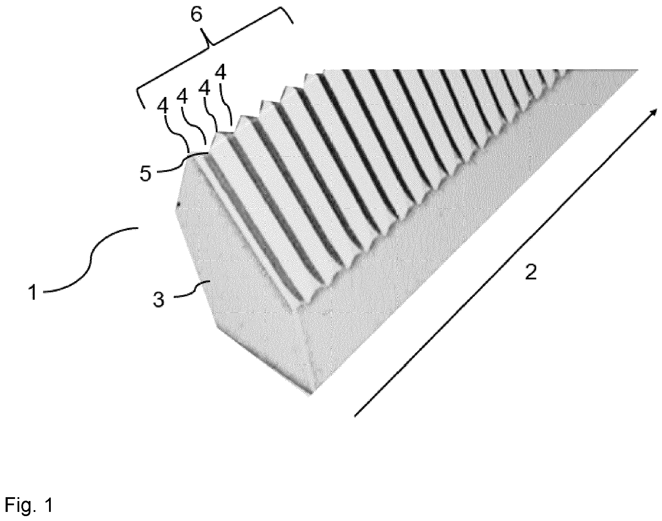

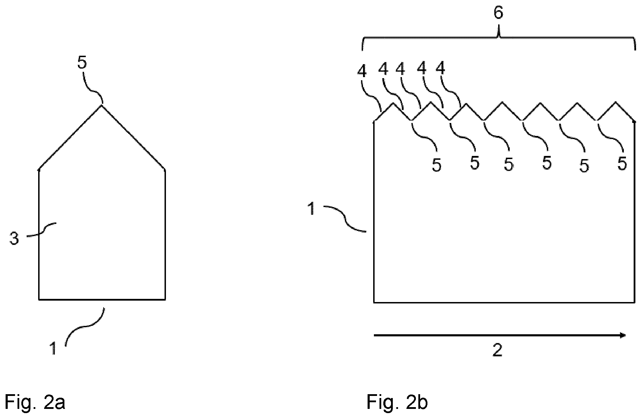

Im Ausführungsbeispiel wurde eine erfindungsgemäße Vorrichtung wie in Fig. 1 dargestellt zur Trocknung von 50 Scheiben aus einkristallinem Silizium mit einem Durchmesser von 300 mm und einer Dicke von 750 µm herangezogen. Der Körper der Vorrichtung verjüngte sich nach oben zu einem Kantenprofil mit Zick-Zack-Form entlang der Haupterstreckungsrichtung (siehe Fig. 2b). Der Körper bestand aus PEEK, wobei der obere Abschnitt der an die Kanten des Kantenprofils angrenzenden Flächen mit einem Gasgemisch aus 5 mol% Fluor und Luft als Spülgas behandelt wurde. Die abfallenden Flächen des Körpers der Vorrichtung wiesen somit einen oberen Abschnitt und einen unteren Abschnitt auf, wobei der obere Abschnitt hydrophiler als der untere Abschnitt war. Die Scheiben wurden auf der oberen Kante in Querrichtung zur Haupterstreckungsrichtung der Vorrichtung stehend, aus einem mit Wasser gefüllten Becken in einen Gasraum mit Isopropanol-Dampf überführt.

In einem Vergleichsbeispiel wurde die gleiche Vorrichtung wie im Ausführungsbeispiel verwendet, mit der Ausnahme, dass die abfallenden Flächen des Körpers der Vorrichtung nicht mit Fluor behandelt wurden. Ansonsten wurde genau wie im Ausführungsbeispiel verfahren.

Die getrockneten Halbleiterscheiben wurden im Bereich der Auflageposition auf dem Körper auf das Vorhandensein von Partikeln untersucht. Der Vergleich des Ausführungsbeispiels mit dem Vergleichsbeispiel zeigte, dass die mit der erfindungsgemäßen Vorrichtung und gemäß dem erfindungsgemäßen Verfahren durchgeführte Trocknung im Ausführungsbeispiel zu erheblich weniger Rückständen auf den getrockneten Scheiben führte.

## Patentansprüche

1. Vorrichtung zum Trocknen von scheibenförmigen Substraten umfassend einen Körper (1) mit einer horizontalen Haupterstreckungsrichtung (2) und einem Querschnittsprofil (3) quer zur Haupterstreckungsrichtung (2), das sich in vertikaler Richtung nach oben verjüngt,
wobei der Körper (1) an seiner Oberseite mehrere Auflagepositionen aufweist, die dafür geeignet sind, scheibenförmige Substrate abzustützen,
die mehreren Auflagepositionen entlang der Haupterstreckungsrichtung (2) angeordnet sind,
an die mehreren Auflagepositionen Flächen des Körpers angrenzen, die ausgehend von den Auflagepositionen abfallen,
zumindest ein Teil der an die Auflagepositionen angrenzenden, abfallenden Flächen des Körpers einen oberen Abschnitt und einen unteren Abschnitt aufweisen, und
der obere Abschnitt hydrophiler als der untere Abschnitt ist.

2. Vorrichtung zum Trocknen von scheibenförmigen Substraten gemäß dem Anspruch 1, **dadurch gekennzeichnet, dass** der Kontaktwinkel α eines Tropfens einer Flüssigkeit auf einer bestimmten Stelle einer Oberfläche als Maß für die Hydrophilie dieser Stelle der Oberfläche herangezogen wird.

3. Vorrichtung zum Trocknen von scheibenförmigen Substraten gemäß dem Anspruch 1 oder 2, **dadurch gekennzeichnet, dass** der Kontaktwinkel α an den an die Auflagepositionen angrenzenden, abfallenden Flächen des Körpers als monoton steigende Funktion des Abstand s von der Auflageposition beschrieben werden kann.

4. Vorrichtung zum Trocknen von scheibenförmigen Substraten gemäß einem der Ansprüche 1 bis 3, **dadurch gekennzeichnet, dass** die Bestimmung des Kontaktwinkels α gemäß dem folgenden Verfahren erfolgt;
(i) Benetzen mindestens einer Stelle des oberen Abschnittes und mindestens einer Stelle des unteren Abschnittes mit jeweils einem Tropfen einer Flüssigkeit;
(ii) Aufnehmen eines Bildes jedes Tropfens;
(iii) Bestimmen der Kontur des jeweiligen Tropfens ausgehend von dem jeweiligen Bild mittels einer geeigneten Software; und
(iv) Bestimmen des Kontaktwinkels zwischen der Oberfläche und dem jeweiligen Tropfen ausgehend von der bestimmten Kontur des jeweiligen Tropfens.

5. Vorrichtung zum Trocknen von scheibenförmigen Substraten gemäß einem der Ansprüche 1 bis 4, **dadurch gekennzeichnet, dass** die Auflagepositionen so ausgestaltet sind, dass die darauf abgestützten scheibenförmigen Substrate quer zur Haupterstreckungsrichtung angeordnet sind.

6. Vorrichtung zum Trocknen von scheibenförmigen Substraten gemäß einem der Ansprüche 1 bis 5, **dadurch gekennzeichnet, dass** das Querschnittsprofil an den Auflagepositionen in seinem oberen Teil einen spitzen Winkel aufweist.

7. Vorrichtung zum Trocknen von scheibenförmigen Substraten gemäß einem der Ansprüche 1 bis 6, **dadurch gekennzeichnet, dass** sich der Körper in vertikaler Richtung nach oben zu einer Kante oder einem Kantenprofil verjüngt.

8. Vorrichtung zum Trocknen von scheibenförmigen Substraten gemäß einem der Ansprüche 1 bis 7, wobei jede Auflageposition durch einen Knick im Kantenprofil gekennzeichnet ist.

9. Vorrichtung zum Trocknen von scheibenförmigen Substraten gemäß einem der Ansprüche 1 bis 8, **dadurch gekennzeichnet, dass** die Auflagepositionen so ausgestaltet sind, dass die darauf abgestützten scheibenförmigen Substrate aus der Vertikalen geneigt sind.

10. Vorrichtung zum Trocknen von scheibenförmigen Substraten gemäß einem der Ansprüche 1 bis 9, **dadurch gekennzeichnet, dass** der Körper so ausgebildet ist, dass die scheibenförmigen Substrate an den Auflagepositionen auf dem höchsten Punkt des jeweiligen Querschnittsprofils aufliegen.

11. Verfahren zum Trocknen von scheibenförmigen Substraten, die in eine Flüssigkeit getaucht sind, umfassend
das Positionieren der in die Flüssigkeit getauchten, scheibenförmigen Substrate auf der Vorrichtung gemäß einem der Ansprüche 1 bis 10; und
das Überführen der scheibenförmigen Substrate mit der Vorrichtung aus der Flüssigkeit in einen Gasraum enthaltend einen Dampf, der auf den scheibenförmigen Substraten nicht kondensiert und die Oberflächenspannung von Flüssigkeitsresten, die an den scheibenförmigen Substraten haften, herabsetzt.

12. Verfahren zum Trocknen von scheibenförmigen Substraten gemäß dem Anspruch 11, umfassend,
das Entfernen von Flüssigkeitsresten zwischen den scheibenförmigen Substraten und dem Körper der Vorrichtung über die an die Auflagepositionen angrenzenden, abfallenden Flächen des Körpers der Vorrichtung.

13. Verfahren zum Trocknen von scheibenförmigen Substraten gemäß dem Anspruch 12, **dadurch gekennzeichnet, dass** darauf verzichtet wird, die Flüssigkeitsreste zwischen den scheibenförmigen Substraten und dem Körper der Vorrichtung aktiv zu entfernen.
